# EUROPEAN PATENT SPECIFICATION

(11) **EP 1 003 354 B1**
(45) Date of publication and mention of the grant of the patent: **28.12.2005**
(21) Application number: 99939247.5
(22) Date of filing: 09.03.1999
(51) Int. Cl.: H05B 33/10

(54) **METHOD OF MANUFACTURING ORGANIC EL DISPLAY**
VERFAHREN ZUR HERSTELLUNG EINER ORGANISCHEN ELEKTROLUMINESZENZANZEIGE
PROCEDE DE FABRICATION D'UN DISPOSITIF ORGANIQUE ELECTROLUMINESCENT

(30) Priority: 09.03.1998 JP 5721498
(43) Date of publication of application: 24.05.2000
(60) Divisional application: 05077308.4
(73) Proprietor: SEIKO EPSON CORPORATION, Shinjuku-ku, Tokyo 163-0811 (JP); MINNESOTA MINING AND MANUFACTURING COMPANY, St. Paul, Minnesota 55133-3427 (US)
(72) Inventor: KOBAYASHI, Hidekazu, Seiko Epson Corporation, Suwa-shi, Nagano 392-8502 (JP); SHIMODA, Tatsuya, Seiko Epson Corporation, Suwa-shi, Nagano 392-8502 (JP); KIGUCHI, Hiroshi, Seiko Epson Corporation, Suwa-shi, Nagano 392-8502 (JP)
(74) Representative: Sturt, Clifford Mark
(86) International application number: PCT/JP1999/001132
(87) International publication number: WO 1999/046961

(56) References cited:
- EP-A- 0 773 707
- JP-A- 10 012 377
- JP-A- 10 208 881

## Description

### TECHNICAL FIELD

The present invention relates to a method for manufacturing an organic EL display device which is used in emissive simple matrix drive-type medium or large volume monochromatic or color displays, camcorder or digital camera view finders, and the like.

### BACKGROUND ART

The difficulty of cathode patterning in simple matrix organic EL displays has been pointed out in the past. This is because the organic layer under the cathode is readily penetrated by solvent. Cathode patterning techniques have thus far been developed to remedy such problems. Examples include the method for RGB 3-color distribution using physical masks as indicated in Japanese Patent Laid-open No.08-227276, and the method for the creation of cathode partition walls for simultaneous cathode patterning during cathode deposition as indicated in US Patent 5,294,869.

As noted on page 913 of the 51" issue (September 21, 1987) of Applied Physics Letters, the structure of most conventional organic EL elements comprises a transparent electrode formed on a glass substrate, where light is transmitted through the glass substrate.

However, high precision fineness and positional alignment are difficult co achieve in methods featuring the use of a physical mask. In addition, the process is complicated in cases of separate cathode walls because an etching process is used to form the separate cathode walls.

Furthermore, the penetration through the glass substrate results in outgoing radiation, and thus in greater light leakage in the direction of the substrate plane, allowing only 20% of the total light emission to be used.

Japanese Patent Publication No. 10208881 discloses forming a first electrode layer on a transparent board. Then forming a donor film comprising a basic film coated with a light absorbing layer and a transfer layer, The donor film is separated from the transparent board by a predetermined space.

### Disclosure of the Invention

An object of the present invention is to provide a method for the extremely simple patterning of electrodes and light emitting layers in methods for manufacturing organic EL display devices, and to provide such a method in which all the light emission is radiated outward in the direction of the visual field without being wasted.

Means 1 for solving the problem: The method for manufacturing an organic EL display device in the present invention is a method for manufacturing an organic EL display device which is used in simple matrix drives, characterised in that a light-heat conversion layer and heat-propagating layer are formed on a film, a cathode layer is then formed, a light emitting layer is then formed thereon, a positive hole-injecting layer is then formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism is connected to the substrate onto which the aforementioned multiple layers have been transferred, and a sealing process is carried out. This structure allows cathodes which are extremely unstable and difficult to pattern to be readily patterned simultaneously with the transfer of the organic EL layer by laser.

Means 2 for solving the problem: The method for manufacturing an organic EL display device in the present invention is a method for manufacturing an organic EL display device which is used in simple matrix drives, characterized in that a light-heat conversion layer and heat-propagating layer are formed on a film, a cathode layer is then formed, an electroluminescent adhesive layer is the formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism connected to the substrate onto which the multiple layers have been transferred, and a sealing process is carried out. This structure allows cathodes with a simple structure, which are extremely unstable and difficult to pattern, to be readily patterned simultaneously with the transfer of the organic EL layer by laser.

Means 3 for solving the problem: This is characterized in that an electron-injecting layer is formed between the cathode layer and light emitting layer of the first means for solving the problem or between the cathode layer and the electroluminescent adhesive layer of the second means for solving the problem. This allows the luminous efficiency to be improved in the aforementioned structures.

Means 4 for solving the problem: The method for manufacturing an organic EL display device that is used in simple matrix drives is characterized in that a light-heat conversion layer and heat-propagating layer are formed on a film, an anode layer is then formed, a positive hole-injecting layer is then formed thereon, a light emitting layer is then formed thereon, an electron-injecting adhesive layer is then formed thereon, the film on which these tiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out. This structure allows cathodes which are difficult to pattern to be readily patterned by means of a laser or the like after being formed on a glass substrate, and also allows anodes to be patterned simultaneously during the subsequent transfer of the organic EL layer. This structure also allows light to be directly transmitted to the outside without passing through the glass substrate from the organic light emitting layer, so that no light is lost, resulting in better brightness.

Means 5 for solving the problem: The method for manufacturing an organic EL display device that is used in simple matrix drives is characterized in that a light-heat conversion layer and heat-propagating layer are formed on a film, an anode layer is then formed, a positive hole-injecting layer is then formed thereon, an electroluminescent adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out.

This structure allows cathodes which are difficult to pattern to be readily patterned by means of a laser or the like after being formed on a glass substrate, and also allows anodes to be patterned simultaneously during the subsequent transfer of the organic EL layer. The manufacturing process is also simplified because the adhesive layer also has a light-emitting function. This structure also allows light to be directly transmitted to the outside without passing through the glass substrate from the organic light emitting layer, so that no light is lost, resulting in better brightness.

Means 6 for solving the problem: This is characterized in that the aforementioned light emitting layer or electroluminescent adhesive layer is formed by applying luminescent substances emitting different-colored light by means of an ink jet head. This means allows different-colored light emitting layers to be readily formed on the film, thereby allowing a colored simple matrix display to be produced with extreme ease.

Means 7 for solving the problem: This is characterized in that means for ink separation between color regions is implemented before said light emitting layer or electroluminescent adhesive layer is applied by an ink jet head. This allows the light emitting layer to be formed in the form of stripes without staining adjacent picture elements

### BRIEF DESCRIPTION OF THE DRAWINGS

Fig. 1 is a cross section illustrating a step for manufacturing the organic EL display device in Embodiment 1.
Fig. 2 is a cross section illustrating a step for manufacturing the organic EL display device in Embodiment 1.
Fig. 3 is a cross section illustrating a step for manufacturing the organic EL display device in Embodiment 1.
Fig. 4 is a cross section illustrating a step for manufacturing the organic EL display device in Embodiment 1.
Fig. 5 is a cross section illustrating a step for manufacturing the organic EL display device in Embodiment 1.
Fig. 6 is a cross section illustrating a step for manufacturing the organic EL display device in Embodiment 1.
Fig. 7 is a cross section illustrating a step for manufacturing the organic EL display device in Embodiment 1.
Fig. 8 is a cross section of the organic EL display device in Embodiment 3.
Fig. 9 is a cross section illustrating a step for manufacturing the organic EL display device in Embodiment 4.
Fig. 10 is a cross section illustrating a step for manufacturing the organic EL display device in Embodiment 4.
Fig. 11 is a cross section illustrating a step for manufacturing the organic EL display device in Embodiment 4.
Fig. 12 is a cross section illustrating a step for manufacturing the organic EL display device in Embodiment 4.
Fig. 13 is a cross section illustrating a step for manufacturing the organic EL display device in Embodiment 4.
Fig. 14 is a cross section illustrating a step for manufacturing the organic EL display device in Embodiment 4.
Fig. 15 is a cross section illustrating a step for manufacturing the organic EL display device in Embodiment 4.
Fig. 16 is a cross section illustrating a step for manufacturing the organic EL display device in Embodiment 4.
Fig. 17 is a cross section illustrating a step for manufacturing the organic EL display device in Embodiment 4.
Fig. 18 is a cross section illustrating a step for manufacturing the organic EL display device in Embodiment 4.
Fig. 19 is a cross section illustrating a step for manufacturing the organic EL display device in Embodiment 5.
Fig. 20 is a cross section illustrating a step for manufacturing the organic EL display device in Embodiment 5.
Fig. 21 is a cross section illustrating a step for manufacturing the organic EL display device in Embodiment 5.
Fig. 22 is a cross section illustrating a step for manufacturing the organic EL display device in Embodiment 5.
Fig. 23 is a cross section illustrating a step for manufacturing the organic EL display device in Embodiment 5.
Fig. 24 is a cross section illustrating a step for manufacturing the organic EL display device in Embodiment 5.
Fig. 25 is a cross section illustrating a step for manufacturing the organic EL display device in Embodiment 5.
Fig. 26 is a cross section illustrating a step for manufacturing the organic EL display device in Embodiment 5.

### BEST MODE FOR CARRYING OUT THE INVENTION

### Embodiment 1

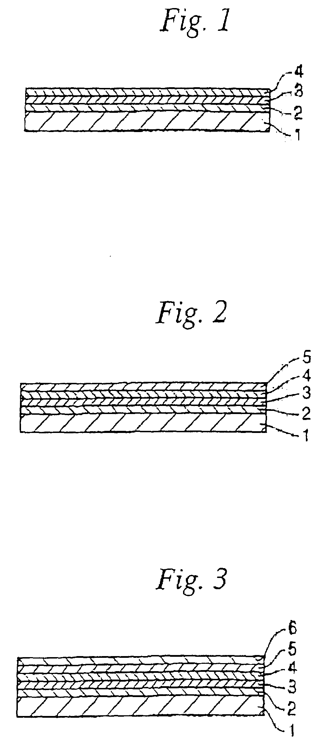

This embodiment is an example of a method for manufacturing an organic EL display device that is used in simple matrix drives, wherein a light-heat conversion layer and heat-propagating layer are formed on a film, a cathode layer is then formed, a light emitting layer is then formed thereon, a positive hole-injecting layer is then formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism is connected to the substrate onto which the aforementioned multiple layers have been transferred, and a sealing process is carried out. Figs. 1 through 6 are simple cross sections depicting the method for manufacturing the organic EL display device in the present invention.

First, a thermosetting epoxy resin in which carbon particles had been mixed was coated to a thickness of 5 microns and cured at room temperature as a layer 2 for converting laser light to heat on a base film 1 comprising a 0.1 mm thick polyethylene terephthalate film. Then, a poly- - methylstyrene film was formed when coated to a thickness of 1 micron as a heat propagating and releas layer 3, and aluminum:lithium (10:1) was deposited to a thickness of 200 nm as a cathode layer 4 on the surface (Fig. 1).

Alq3 was then deposited to a thickness of 70 nm as the light emitting layer (Fig. 2).

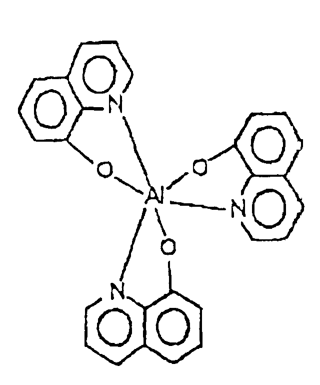

A mixture of NPD and polyvinyl carbazol was then dissolved in solvent, and was coated and dried to a thickness of 60 nm as the positive hole-injecting adhesive layer 6 (Fig. 3).

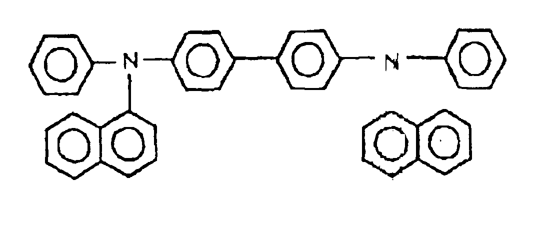

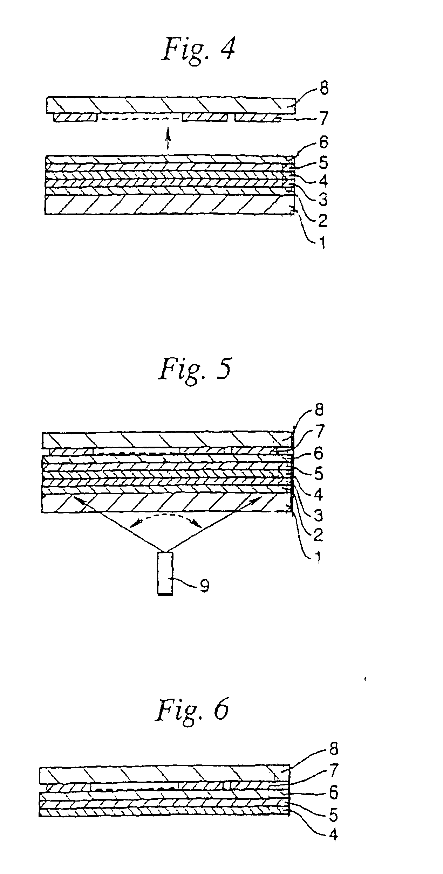

The resulting film was then placed in contact with a transparent glass substrate 8 with a patterned ITO having 256 stripes (Fig. 4).

A pattern of 64 stripes was then produced with a 13 W YAG laser 9 on the film side so as to intersect the striped pattern of the ITO (Fig. 5).

The film was then removed, giving an organic EL substrate with 256 x 64 picture elements having the structure depicted in Fig. 6.

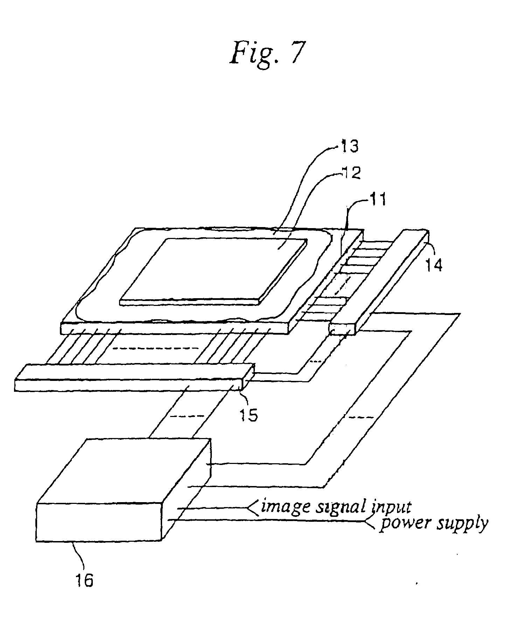

Drivers 14 and 15 and a controller 16 were then connected to the organic EL substrate 11, as shown in Fig. 7, a transparent protective substrate was placed in contact with UV setting sealant 13, and the protective substrate was cured and sealed by irradiation with UV rays. Moving image display could thus be achieved with the input of drive power and signals to the display device thus obtained.

General resins such as polycarbonates and polyether sulfones can also be used in addition to polyesters as the transfer film used in this embodiment.

Any material that can efficiently convert laser light to heat may similarly be used in addition to carbon-kneaded resins as the material for the light-heat conversion layer used in this embodiment.

Any low melting point (preferably around 100°C) material capable of withstanding the production of heat during the formation of the electrodes can similarly be used in addition to those indicated here as the heat propagating layer used in this embodiment.

Aluminum, lithium, magnesium, calcium, alloys thereof, halogenated compounds, and the like can be used as the material for forming the cathode in this embodiment.

Metal complexes such as quinoline, metal complexes such as azomethine, conjugated low molecule weight species and conjugated high molecular weight species or any other such organic EL materials can be used as the light-emitting material used in this embodiment. The method for forming the film is not limited to deposition. The film can also be formed when the material is coated after being dissolved in a solvent.

In terms of the light emitting layer and anode, any material capable of injecting positive holes into the light emitting layer, such as triphenylamine derivatives, porphin compounds, polyaniline and its derivatives, and polythiophene and its derivatives, can be used in addition to NPD as the positive hole-injecting material used in this embodiment.

Any resin that does not hamper positive hole injection, that can be melted by heat from laser light, and that has excellent adhesion on ITO and glass can be used as the material used for the adhesive layer in this embodiment.

Thermosetting resins other than UV setting resin can similarly be used as the sealant used in this embodiment.

### Embodiment 2

This embodiment is an example of a method for manufacturing an organic EL display device that is used in simple matrix drives, wherein a light-heat conversion layer and heat-propagating layer are formed on a film, a cathode layer is then formed, an electroluminescent adhesive layer is then formed thereon, the film on which these multiple layers have been formed is then placed in contact with a substrate with a stripe-patterned ITO, the aforementioned multiple layers are transferred onto the substrate by irradiating the other side of the film with a laser in such a way as to form the shape of the cathode, the film is then removed, a drive mechanism is connected to the substrate onto which the multiple layers have been transferred, and a sealing process is carried out.

A light-heat conversion layer and heat propagating layer cathode were first formed on a base film in the same manner as in the first embodiment, and MEH-PPV was made into a film in the form of a chloroform solution and dried to a thickness of 70 nm as the electroluminescent adhesive layer.

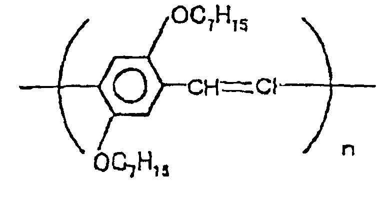

The resulting film was then placed contact with a transparent glass substrate with a patterned ITO in the same manner as in the first embodiment, and a driver circuit was mounted and sealed, giving an organic EL display device.

Moving image display could thus be achieved with the input of drive power and signals to the display device thus obtained.

### Embodiment 3

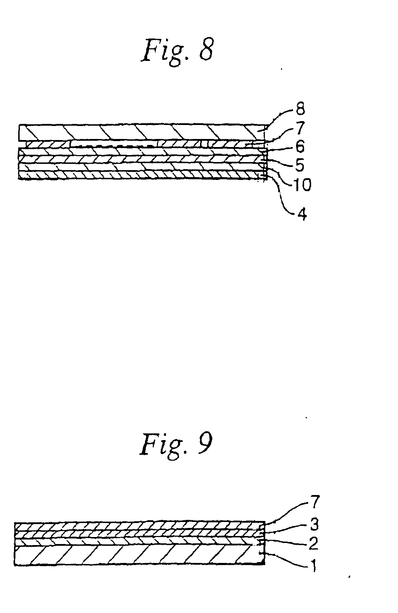

This embodiment is an example of an electron-injecting layer formed between the cathode and light emitting layer in the first embodiment. Fig. 8 is a simple dross section of the organic EL display device in this embodiment. After the cathode in Embodiment 1 had been formed, Znq2 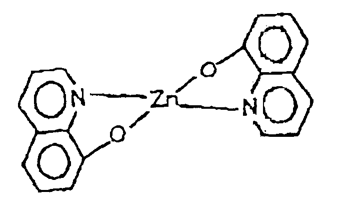 was deposited to a thickness of 20 nm as an electron-injecting layer 10. The light emitting layer and other layers thereafter were then formed in the same manner as in Embodiment 1, giving an organic EL display device.

The organic EL display device in Embodiment 1 had a luminous efficiency of 21 m/W, whereas this embodiment had a luminous efficiency of 2.51 m/W.

In terms of the light emitting layer and anode, any material capable of positive hole injection, such as polyphenylene vinylene derivatives, organometal complexes such as Alq3, and the like, can be used in addition to NPD as the electron-injecting material used in this embodiment. Any method that does not penetrate the cathode can be used as the method for forming the film.

This embodiment can similarly be used in Embodiment 2.

### Embodiment 4

This embodiment is an example of a method for manufacturing an organic EL display device that is used in simple matrix drives, wherein a light-heat conversion layer and heat-propagating layer are formed on a film, an anode layer is then formed, a positive hole-injecting layer is then formed thereon, a light emitting layer is then formed thereon, an electron-injecting adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out. Figs. 9 through 14 are simple cross sections depicting the method for manufacturing the organic EL display device in the present invention.

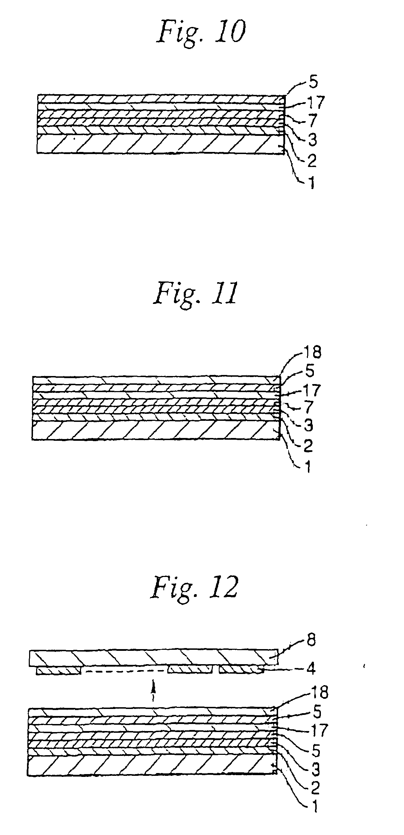

First, the light-heat conversion layer 2 and heat propagating layer 3 given in Embodiment 1 were formed on a base film 1 comprising a 1 mm thick polycarbonate film, and indium tin oxide was formed by sputtering to a thickness of 200 nm as an anode layer 7 (Fig. 9). 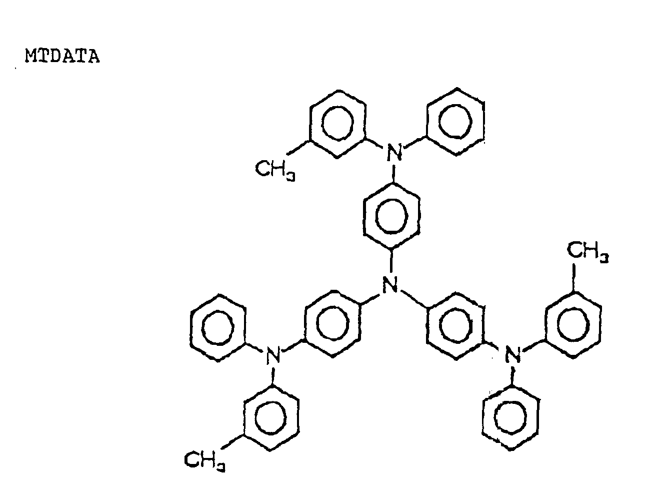 was then deposited to a thickness of 15 as the positive hole-injecting layer 17, and NPD was then deposited to a thickness of 20 nm. Alq3 was then deposited to a thickness of 70 nm as the light emitting layer 5 (Fig. 10).

A chloroform solution of PPV was then applied to a thickness of 60 nm as an electron-injecting adhesive layer 18 (Fig. 11).

The resulting film was then placed in contact with a transparent glass substrate having an aluminum and lithium alloy cathode patterned with 256 stripes laser (Fig. 12).

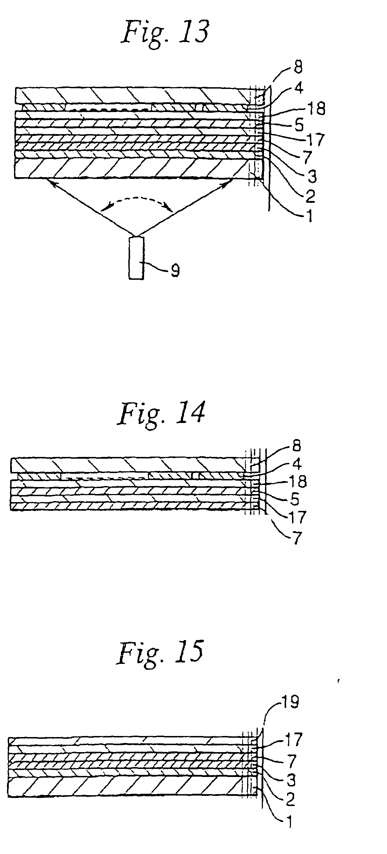

A pattern of 64 stripes was then produced with W YAG laser 9 on the film side so as to intersect the striped pattern of the ITO (Fig. 13).

The film was then removed, giving the organic EL substrate with 256 x 64 picture elements having the structure depicted in Fig. 14.

Drivers and a controller were then connected to the organic EL substrate, as shown in Fig. 7, a transparent protective substrate was placed in contact with an epoxy thermosetting sealant, and the protective substrate was cured and sealed at room temperature. Moving image display could thus be achieved with the input of drive power and signals to the display device thus obtained. The luminous efficiency was 31 m/W.

The same materials and methods given in Embodiment 1 can be used in this embodiment as well.

### Embodiment 5

This embodiment is an example of a method for manufacturing an organic EL display device that is used in simple matrix drives, wherein a light-heat conversion layer and heat-propagating layer are formed on a film, an anode layer is then formed, a positive hole-injecting layer is then formed thereon, an electroluminescent adhesive layer is then formed thereon, the film on which these multiple layers have been formed is then placed in contact with a substrate with a patterned cathode, the other side of the film is irradiated with a laser in such a way as to form the shape of the cathode, the film is then removed, a drive mechanism is connected to the substrate onto which the aforementioned multiple layers have been transferred, and a sealing process is carried out.

Figs. 15 through 18 are simple cross sections depicting the method for manufacturing the organic EL display device in the present invention. An anode and positive hole-injecting layer were formed on a base film in the same manner as in Embodiment 3. A chloroform solution of PPV 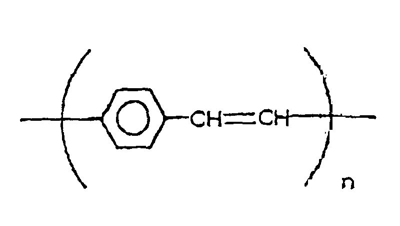 was then coated and dried to a thickness of 60 nm as an electroluminescent adhesive layer 19 (Fig. 15).

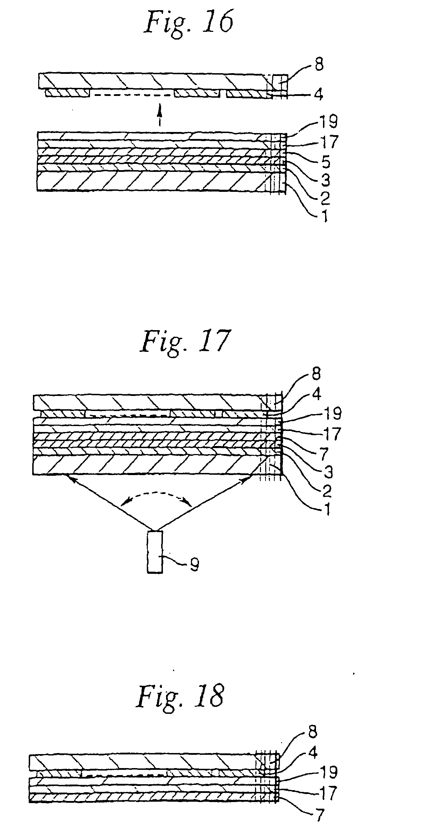

The resulting film was then placed in contact with a transparent glass substrate 8 having an aluminum and lithium alloy cathode 4 patterned with 256 stripes by laser (Fig. 16).

A pattern of 64 stripes was then produced with a 13 W YAG laser 9 on the film side so as to intersect the striped pattern of the ITO (Fig. 17).

The film was then removed, giving the organic EL substrate with 256 x 64 picture elements having the structure depicted in Fig. 18.

Drivers and a controller were then connected to the organic EL substrate, as shown in Fig. 7, a transparent protective substrate was placed in contact with a UV setting sealant, and the protective substrate was cured and sealed at room temperature by being irradiated with UV rays from behind. Moving image display could thus be achieved with the input of drive power and signals to the display device thus obtained. The luminous efficiency was 3.51 m/W.

The same materials and methods given in Embodiment 1 can be used in this embodiment as well.

### Embodiment 6

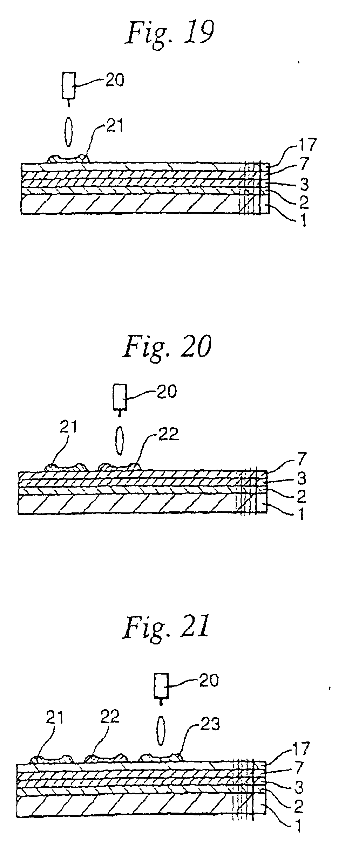

This embodiment is an example of luminescent substances emitting red, green, and blue light, which are dissolved and applied using an ink jet head to form the aforementioned light emitting layer during the formation of the light emitting layer in Embodiment 4. Figs. 19 through 25 are simple cross sections depicting the method for manufacturing the organic EL display device in the present invention.

Layers were first prepared in the same manner as in Embodiment 4 up to the formation of the cathode on the film.

Then, as shown in Fig. 19, a xylene solution of MEH-PPV was applied and dried in the form of a stripe by an ink jet head 20 to form a red-light emitting layer 21. Then, as shown in Fig. 20, a xylene solution of PPV was applied and dried in the form of a stripe by the ink jet head to form a green light emitting layer 22 next to the above layer. Then, as shown in Fig. 21, a xylene solution of a fluorene compound 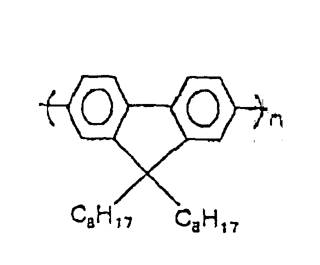 was applied and dried in the form of a stripe by the ink jet head to form a blue light emitting layer 23 between the aforementioned MEH-PPV and PPV derivatives.

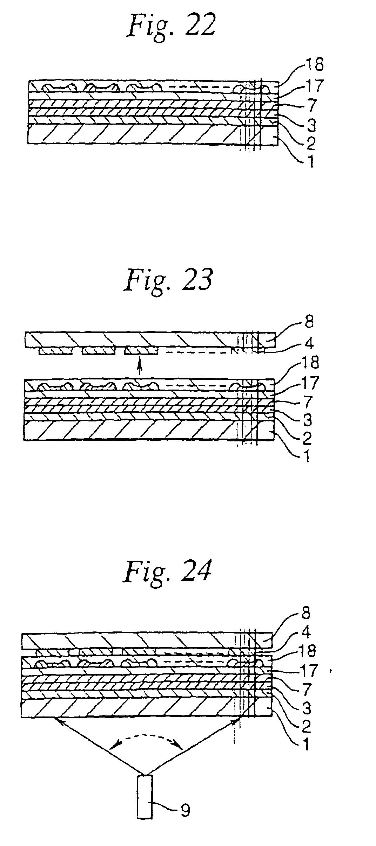

Then, PPV was dissolved in solvent and was coated and dried to a thickness of 60 nm an electron-injecting adhesive layer 18 (Fig. 22).

The resulting film was then placed in contact with a transparent glass substrate 8 having an aluminum and lithium alloy cathode 4 patterned with 256 stripes by laser, where the stripes of the light emitting layers were aligned with the stripes of the cathode (Fig. 23).

A pattern of 64 stripes was then produced with a YAG laser 7 on the film side so as to intersect the striped pattern of the cathode 2 (Fig. 24).

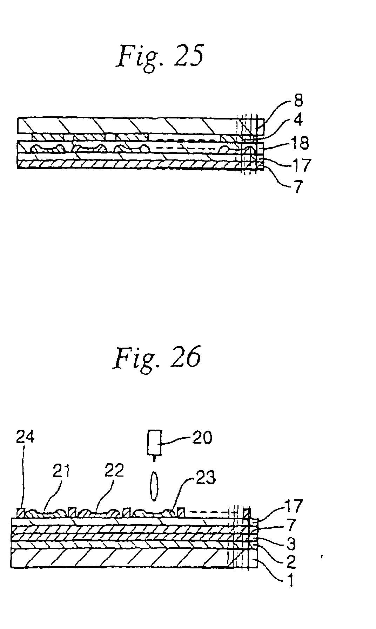

The film was then removed, giving the organic EL substrate with 256 x 64 picture elements having the structure depicted in Fig. 25.

Drivers and a controller were then connected to the organic EL substrate, as shown in Fig. 7, a transparent protective substrate was placed in contact with an epoxy thermosetting sealant to the anode, and moving image display could be achieved with the input of drive power and signals.

The same materials and manufacturing conditions given in Embodiment 4 can be used in this embodiment as well.

This embodiment was carried out with the structure given in Embodiment 4, but it can similarly be applied in the preparation of the light emitting layers or electroluminescent adhesive layers in the other embodiments.

### Embodiment 7

This embodiment is an example of the formation of partition walls in the light emitting layer prior to the formation of the cathode on the film. As shown in Fig. 26, partition walls 24 were printed in the widthwise direction between the colored light emitting layers by means of screen printing using thermosetting polyimide, and were heated and cured on the film used in Embodiment 5. An organic EL display device was then obtained in the same manner as in Embodiment 6.

The use of the resulting display device for color display allowed extremely bright display to be achieved without any color confusion.

The materials and methods used to form partition walls are not limited to those given here. Any other material and method capable of manufacturing the structure depicted in Fig. 26 can be used.

Although a partition wall structure was used as the element means between the colored light emitting layers here, ink may also be applied between picture elements following the formation of the electrode.

### INDUSTRIAL APPLICABILITY

Although it has been extremely difficult to pattern chemically unstable cathodes in the past, the present application allows such cathodes to be readily patterned. The elemental structure can be the reverse of conventional structures, making it possible to suppress the loss of light that is caused by the effects of moving light when emitted light passes through a glass substrate. An organic EL display with high luminous efficiency can thus be inexpensively produced by a simple method.

## Claims

1. A method for producing an organic EL display device used in simple matrix drives, wherein said method for producing an organic EL display device is **characterised by** comprising the steps of:
forming a light-heat conversion layer(2) and heat-propagating layer (3) on a film (1);
forming a cathode layer (4);
forming a light emitting layer (5) thereon;
forming a positive hole-injecting layer (6) thereon;
placing the film (1) on which these multiple layers have been formed in contact with a substrate (8) with a stripe-patterned ITO;
transferring said multiple layers onto the substrate (8) by irradiating the other side of the film (1) with a laser in such a way as to form the shape of the cathode;
removing the film (1);
connecting the drive mechanism to the substrate (8) onto which said multiple layers have been transferred and
carrying out a sealing process.

2. A method for producing an organic EL display device used in simpler matrix drives, wherein said method for producing an organic EL display device is **characterised by** comprising the steps of:
forming a light-heat conversion layer (2) and heat-propagating layer (3) on a film (1);
forming a cathode layer (4);
forming an electroluminescent adhesive layer thereon;
placing the film (1) on which these multiple layers have been formed in contact with a substrate (8) with a stripe-patterned ITO;
transferring said multiple layers onto the substrate (8) by irradiating the other side of the film (1) with a laser in such a way as to form the shape of the cathode;
removing the film (1);
connecting a drive mechanism to the substrate (8) onto which the multiple layers have been transferred; and
carrying out a sealing process.

3. The method for manufacturing an organic EL display device according to claim 1 or 2, **characterised in that** an electron-injecting layer (10) is formed between said cathode layer (4) and said electroluminescent adhesive layer or said light emitting layer (5).

4. A method for producing an organic EL display device used in simple matrix drives, wherein said method for producing an organic EL display device is **characterised by** comprising the steps of:
forming a light-heat conversion layer (2) and heat-propagating layer (3) on a film (1);
forming an anode layer (7);
forming a positive hole-injecting layer (17) thereon;
forming a light emitting layer (5) thereon;
forming an electron-injecting adhesive layer (18) thereon;
placing the film (1) on which these multiple layers have been formed in contact with a substrate (8) with a patterned cathode;
irradiating the other side of the film (1) with a laser in such a way as to form the shape of the cathode;
removing the film (1);
connecting a drive mechanism to the substrate (8) onto which said multiple layers have been transferred; and
carrying out a sealing process.

5. A method for producing an organic EL display device used in simple matrix drives, wherein said method for producing an organic EL display device is **characterised by** comprising the steps of:
fonning a light-heat conversion layer (2) and heat-propagating layer (3) on a film (1);
forming an anode layer (7);
forming a positive hole-injecting layer (17) thereon;
forming an electroluminescent adhesive layer thereon;
placing the film (1) on which these multiple layers have been formed in contact with a substrate (8) with a patterned cathode;
irradiating the other side of the film (1) with a laser in such a way as to form the shape of the cathode;
removing the film (1);
connecting a drive mechanism to the substrate onto which said multiple layers have been transferred; and
carrying out a sealing process.

6. The method for manufacturing an organic EL display device according to claim 1, 2, 4, or 5, **characterised in that** said light emitting layer (5) or electroluminescent adhesive layer is formed by applying luminescent substances emitting different-colored light by means of an ink jet head.

7. The method for manufacturing an organic EL display device according to claim 6, **characterised in that** means for ink separation between color regions is implemented before said light emitting layer (5) or electroluminescent adhesive layer is applied by an ink jet head.

## Patentansprüche

1. Verfahren zum Herstellen eines organischen Elektrolumineszenzdisplays, das in Kombination mit einfachen Matrixansteuerungen verwendet wird; wobei das Verfahren zum Herstellen eines organischen Elektrolumineszenzdisplays die Schritte aufweist:
Ausbilden einer Licht-Wärme-Umwandlungsschicht (2) und einer Wärmeausbreitungsschicht (3) auf einem Film (1);
Ausbilden einer Kathodenschicht (4);
Ausbilden einer lichtemittierenden Schicht (5) darauf;
Ausbilden einer positiven Löcherinjektionsschicht (6) darauf;
Anordnen des Films (1), auf dem diese mehreren Schichten ausgebildet worden sind, in Kontakt mit einem Substrat (8) mit einem streifenförmigen ITO-Muster;
Übertragen der mehreren Schichten auf das Substrat (8) durch Bestrahlen der anderen Seite des Films (1) durch einen Laser derart, dass die Form der Kathode ausgebildet wird;
Entfernen des Films (1);
Verbinden eines Antriebsmechanismus mit dem Substrat (8), auf das die mehreren Schichten übertragen worden sind; und
Ausführen eines Versiegelungsprozesses.

2. Verfahren zum Herstellen eines organischen Elektrolumineszenzdisplays, das in Kombination mit einfachen Matrixansteuerungen verwendet wird, wobei das Verfahren zum Herstellen eines organischen Elektrolumineszenzdisplays die Schritte aufweist:
Ausbilden einer Licht-Wärme-Umwandlungsschicht (2) und einer Wärmeausbreitungsschicht (3) auf einem Film (1) ;
Ausbilden einer Kathodenschicht (4);
Ausbilden einer elektrolumineszierenden Klebstoffschicht darauf;
Anordnen des Films (1), auf dem diese mehreren Schichten ausgebildet worden sind, in Kontakt mit einem Substrat (8) mit einem streifenförmigen ITO-Muster;
Übertragen der mehreren Schichten auf das Substrat (8) durch Bestrahlen der anderen Seite des Films (1) durch einen Laser derart, dass die Form der Kathode ausgebildet wird;
Entfernen des Films (1);
Verbinden eines Antriebsmechanismus mit dem Substrat (8), auf das die mehreren Schichten übertragen worden sind; und
Ausführen eines Versiegelungsprozesses.

3. Verfahren nach Anspruch 1 oder 2, **dadurch gekennzeichnet, dass** eine Elektroneninjektionsschicht (10) zwischen der Kathodenschicht (4) und der elektrolumineszierenden Klebstoffschicht oder der lichtemittierenden Schicht (5) ausgebildet wird.

4. Verfahren zum Herstellen eines organischen Elektroluminaszenzdisplays, das in Kombination mit einfachen Matrixansteuerungen verwendet wird, wobei das Verfahren zum Herstellen eines organischen Elektrolumineszenzdisplays die Schritte aufweist:
Ausbilden einer Licht-Wärme-Umwandlungsschicht (2) und einer Wärmeausbreitungsschicht (3) auf einem Film (1);
Ausbilden einer Anodenschicht (7);
Ausbilden einer positiven Löcherinjektionsschicht (17) darauf;
Ausbilden einer lichtemittierenden Schicht (5) darauf;
Ausbilden einer elektroneninjizierenden Klebstoffschicht (18) darauf;
Anordnen des Films (1), auf dem diese mehreren Schichten ausgebildet worden sind, in Kontakt mit einem Substrat (8), das ein Kathodenmuster aufweist;
Bestrahlen der anderen Seite des Films (1) durch einen Laser derart, dass die Form der Kathode ausgebildet wird;
Entfernen des Films (1);
Verbinden eines Antriebsmechanismus mit dem Substrat (8), auf das die mehreren Schichten übertragen worden sind; und
Ausführen eines Versiegelungsprozesses.

5. Verfahren zum Herstellen eines organischen Elektrolumineszenzdisplays, das in Kombination mit einfachen Matrixansteuerungen verwendet wird, wobei das Verfahren zum Herstellen eines organischen Elektrolumineszenzdisplays die Schritte aufweist:
Ausbilden einer Licht-Wärme-Umwandlungsschicht (2) und einer Wärmeausbreitungsschicht (3) auf einem Film (1);
Ausbilden einer Anodenschicht (7);
Ausbilden einer positiven Löcherinjektionsschicht (17) darauf;
Ausbilden einer elektrolumineszierenden Klebstoffschicht darauf;
Anordnen des Films (1), auf dem diese mehreren Schichten ausgebildet worden sind, in Kontakt mit einem Substrat (8), das ein Kathodenmuster aufweist;
Bestrahlen der anderen Seite des Films (1) durch einen Laser derart, dass die Form der Kathode ausgebildet wird;
Entfernen des Films (1);
Verbinden eines Antriebsmechanismus mit dem Substrat, auf das die mehreren Schichten übertragen worden sind; und
Ausführen eines Versiegelungsprozesses.

6. Verfahren nach Anspruch 1, 2, 4 oder 5, **dadurch gekennzeichnet, dass** die lichtemittierende Schicht (5) oder die elektrolumineszierende Klebstoffschicht durch Aufbringen lumineszenter Substanzen, die verschieden farbiges Licht emittieren, durch einen Tintenstrahl-Druckkopf hergestellt wird.

7. Verfahren nach Anspruch 6, **dadurch gekennzeichnet, dass** eine Farbtrennung zwischen Farbbereichen implementiert wird, bevor die lichtemittierende Schicht (5) oder die elektrolumineszierende Klebstoffschicht durch einen Tintenstrahl-Druckkopf aufgebracht wird.

## Revendications

1. Procédé de production d'un dispositif d'écran électroluminescent organique utilisé dans des commandes à matrice simple, dans lequel ledit procédé de production d'un dispositif d'écran électro-luminescent organique est **caractérisé en ce qu'**il comprend les étapes consistant à
former une couche de conversion lumière-chaleur (2) et une couche de propagation de chaleur (3) sur un film (1) ;
former une couche de cathode (4) ;
former une couche photo-émettrice (5) ;
former une couche positive d'injection de trous (6) ;
placer le film (1) sur lequel ces couches multiples ont été formées en contact avec un substrat (8) ayant un ITO selon un motif en ruban ;
transférer lesdites couches multiples sur le substrat (8) en irradiant l'autre face du film (1) avec un laser de manière à mettre en forme la cathode ;
retirer le film (1) ;
connecter un mécanisme de commande au substrat (8) sur lequel lesdites couches multiples ont été transférées ; et
effectuer le procédé de scellement.

2. Procédé de production d'un dispositif d'écran électroluminescent organique utilisé dans des commandes à matrice simple, dans lequel ledit procédé de production d'un dispositif d'écran électro-luminescent organique est **caractérisé en ce qu'**il comprend les étapes consistant à
former une couche de conversion lumière-chaleur (2) et une couche de propagation de chaleur (3) sur un film (1) ;
former une couche de cathode (4) ;
former une couche adhésive électroluminescente ;
placer le film (1) sur lequel ces couches multiples ont été formées en contact avec un substrat (8) ayant un ITO selon un motif en ruban ;
transférer lesdites couches multiples sur le substrat (8) en irradiant l'autre face du film (1) avec un laser de manière à mettre en forme la cathode ;
retirer le film (1) ;
connecter un mécanisme de commande au substrat (8) sur lequel lesdites couches multiples ont été transférées ; et
effectuer le procédé de scellement.

3. Procédé de fabrication d'un dispositif d'écran électroluminescent organique selon la revendication 1 ou 2, **caractérisé en ce que** l'on forme une couche d'injection d'électrons (10) entre ladite couche de cathode (4) et ladite couche adhésive électroluminescente ou ladite couche photo-émettrice (5).

4. Procédé de production d'un dispositif d'écran électroluminescent organique utilisé dans des commandes à matrice simple, dans lequel ledit procédé de production d'un dispositif d'écran électro-luminescent organique est **caractérisé en ce qu'**il comprend les étapes consistant à
former une couche de conversion lumière-chaleur (2) et une couche de propagation de chaleur (3) sur un film (1) ;
former une couche d'anode (7) ;
former une couche positive d'injection de trous (17) ;
former une couche photo-émettrice (5) ;
former une couche adhésive d'injection d'électrons (18) ;
placer le film (1) sur lequel ces couches multiples ont été formées en contact avec un substrat (8) ayant une cathode selon un motif ;
irradier l'autre face du film (1) avec un laser de manière à mettre en forme la cathode ;
retirer le film (1) ;
connecter un mécanisme de commande au substrat (8) sur lequel lesdites couches multiples ont été transférées ; et
effectuer le procédé de scellement.

5. Procédé de production d'un dispositif d'écran électroluminescent organique utilisé dans des commandes à matrice simple, dans lequel ledit procédé de production d'un dispositif d'écran électro-luminescent organique est **caractérisé en ce qu'**il comprend les étapes consistant à
former une couche de conversion lumière-chaleur (2) et une couche de propagation de chaleur (3) sur un film (1) ;
former une couche d'anode (7) ;
former une couche positive d'injection de trous (17) ;
former une couche adhésive électroluminescente ;
placer le film (1) sur lequel ces couches multiples ont été formées en contact avec un substrat (8) ayant une cathode selon un motif ;
irradier l'autre face du film (1) avec un laser de manière à mettre en forme la cathode ;
retirer le film (1) ;
connecter un mécanisme de commande au substrat sur lequel lesdites couches multiples ont été transférées ; et
effectuer le procédé de scellement.

6. Procédé de production d'un dispositif d'écran électroluminescent organique selon la revendication 1, 2, 4 ou 5, **caractérisé en ce que** ladite couche photo-émettrice (5) ou la couche adhésive électroluminescente est formée en appliquant des substances luminescentes émettant de la lumière de couleurs différentes au moyen d'une tête d'impression à jet d'encre.

7. Procédé de production d'un dispositif d'écran électroluminescent organique selon la revendication 6, **caractérisé en ce qu'**un élément de séparation des encres entre les régions colorées est implanté avant d'appliquer ladite couche photo-émettrice (5) ou la couche adhésive électro-luminescente par une tête d'impression à jet d'encre.
